# EUROPEAN PATENT APPLICATION

(11) **EP 1 512 699 A1**
(43) Date of publication of application: **09.03.2005**
(21) Application number: 03102659.4
(22) Date of filing: 27.08.2003
(51) Int. Cl.: C08F 4/02, C08F 10/00, C01F 5/30

(54) **Catalyst Support**

(71) Applicant: TOTAL PETROCHEMICALS RESEARCH FELUY, 7181 Seneffe (Feluy) (BE)
(72) Inventor: Razavi, Abbas, B-7000, Mons (BE)

(57) **Abstract**

The present invention discloses a solid support having a crystal lattice with crystal faces that are modified with respect to orientation characterised in that an olefin polymerisation catalyst or a pre-catalyst thereof is immobilised on the modified crystal faces. It also discloses a method for preparing said support.

## Description

The present invention concerns a new solid support for an olefin polymerisation catalyst and a method for making the same. The invention further concerns a method for producing stereoregular polyolefins using a support according to this invention. The invention also relates to polyolefins produced using the method of the invention. The invention is especially effective when applied to a Ziegler-Natta, metallocene or post-metallocene type catalyst system.

Olefins having three or more carbon atoms can be polymerised to produce a polymer with an isotactic stereochemical configuration. This means that in a polymer having general formula [-CH₂-CHR-]ₙ, all of the substituted carbons have the same stereo configuration and, with a hypothetical straight chain, all the substituents are on the same side of the chain. In the case of polypropylene, this can be represented as:

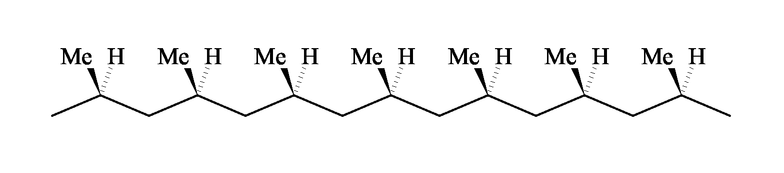

Isotactic and syndiotactic polypropylenes are prepared by polymerisation using stereospecific catalysts. In this regard, three classes of catalyst system may be mentioned.

A first class is the Ziegler-Natta catalyst systems. A Ziegler-Natta catalyst system comprises a pre-catalyst and an activating agent. The pre-catalyst is a transition metal derivative, typically a halide or ester of a transition metal, such as TiCl₄. The activating agent is an organometallic derivative where the metal belongs to the main groups I, II or III.

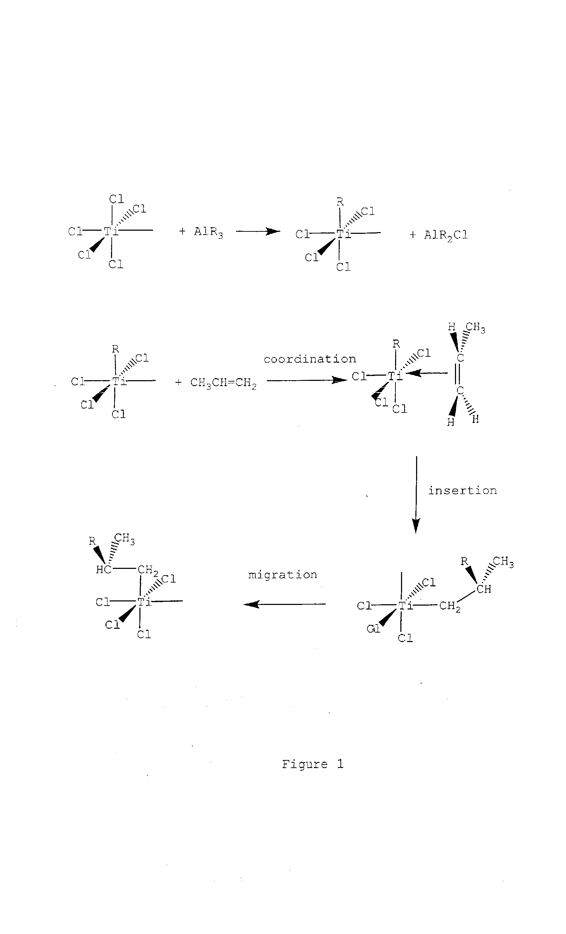

An example of a Ziegler-Natta catalyst system is (C₂H₅)₃Al/TiCl₄. A proposed mechanism for polymerisation using this catalyst system is shown in Figure 1.

It can be seen from Figure 1 that in order to obtain a stereoregular polymer, the absorption of the monomer on the catalyst surface must be controlled so that orientation of the incoming monomer always is the same.

In the case of iso-selective Ziegler-Natta catalysts, the delta/lambda chirality of the Ti sites, embedded in the three - dimensional lattice, combined with proper local symmetry environment, provides the necessary and sufficient conditions for the formation of a stereoregular olefin polymer, for example, isotactic polypropylene.

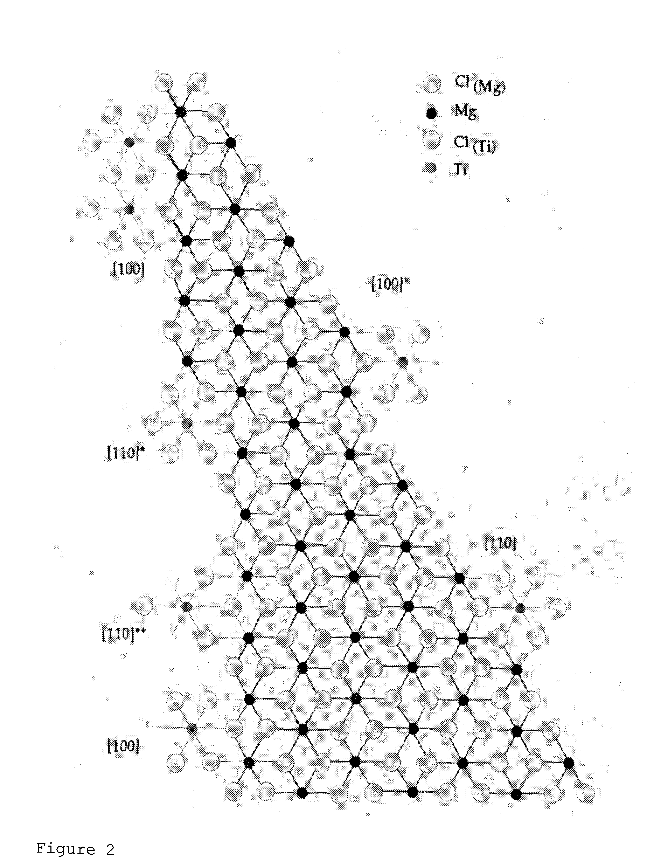

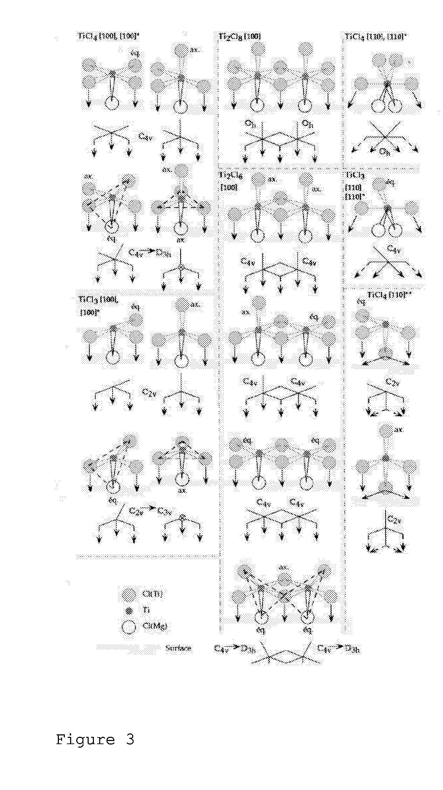

Figures 2 and 3 show TiCl₄ supported on MgCl₂, which when treated with an aluminium alkyl is transformed into the α(,α,α) - modification of TiCl₃. The crystal structure of the support is isomorphous with the crystal structure of the TiCl₃. Growth of the TiCl₃ on the support is epitactic.

Two approaches may be considered for the formation of TiCl₃ supported on MgCl₂.

A first approach uses TiCl₃ as a starting material. TiCl₃ exists in the form of a solid. In the lattice structure, the Ti centres have inherent chirality. The TiCl₃ may be immobilised on a support, however, heterogenisation of this catalyst in fact is optional.

A second approach uses TiCl₄ as a starting material. This is a liquid and so, in use, it is supported/heterogenized, for example on MgCl₂. The Ti centres in TiCl₄ do not have inherent chirality. Therefore, the supported TiCl₄ must be activated. A suitable activating agent is AlEt₃. This will transform the supported TiCl₄ to supported TiCl₃ that is active and chiral.

As mentioned above, the symmetry environment of the Ti centres is very important for controlling the stereochemical configuration of a polyolefin product. However, it will be seen particularly from Figure 2 that the exposed Ti centres do not have inherent chirality on all crystallographic planes. Taking the case shown in Figure 2 as an example, it can be seen that [100] and [110] crystallographic planes are present. [110] faces are believed to be responsible for the formation of atactic sites in the active catalyst whereas perfect [100] crystallographic planes lead to the formation of highly stereospecific sites. Unfortunately, TiCl₃ will grow on both of these faces although only the [100] faces will be useful for catalysing the formation of a stereoregular polyolefin such as isotactic polypropylene.

It is known to use a chiral "modifier" molecule in order to induce enantioselectivity in a heterogeneous catalytic s ystem that uses a metal catalyst. The chiral "modifier" molecule is adsorbed onto the reactive metal surface. A variety of ordered overlaid structures are produced in which preferred molecular forms, bonding and orientations of the chiral molecules are adopted on the metal surface. These forms are dependent on coverage, temperature and time. The different ad layers play a different role in the enantioselective reaction. J. Phys. Chem. B 1999, 103, page 10661-10669 describes in particular that under certain conditions, the two-dimensional order of an R, R-tartaric acid ad layer on a Cu [110] surface destroys all symmetry elements at the surface, leading to the creation of extended chiral surfaces. Such chiral surfaces may be an important factor in defining the active site in heterogeneous enantioselective reactions. This document does not mention at all the possibility of using the chiral modifier molecules in the production of polyolefins.

It is also known to use so-called internal agents, employed as solvent, solution or internal donors, in order to selectively poison sites not having the desired/correct environment. In the case of TiCl₃ supported on MgCl₂, an organic agent that is an electron donor may be used as a selective "poison". The purpose of the internal agent is to eliminate faces with non -chiral Ti centres. This is achieved by the internal agent (electron donor) co-ordinating to and blocking a highly electrophilic Mg site on a [110] face.

Unfortunately, it has been found that in the majori ty of cases, the "poison" is removed by the activating agent. Therefore, work has been done in order to try to find new organic materials that are electron donors that are suitable for use as selective "poisons" and that are not removed by the activating agent.

Despite work done in this field to discover new and more effective electron donors, the method of selectively "poisoning" sites not having the correct/desirable environment is not entirely satisfactory. This is in part because the addition of an electron donor during processing increases the number of steps in the process, increases the cost of the process and, also, has environmental effects due to the nature of the electron donors that may be used.

In view of the advantages of stereoregular po lyolefins, it will be appreciated that polymerisation methods that allow selection of the tacticity of the polymer product so as to be able to produce selectively, for example, an isotactic polyolefin are highly desirable. Whilst some methods for controll ing the polymer architecture and microstructure already are known, it is highly desirable to provide alternative methods for controlling polymer architecture and microstructure or methods that can further enhance existing control over polymer architecture and microstructure.

In this regard, the present inventors have appreciated the importance of the topological chirality of crystalline faces of a catalyst/support lattice for controlling the stereospecific performance of the final catalyst.

As such, the present inventors have at least partially addressed the problems outlined above by providing, in a first aspect of the present invention, a solid support for an olefin polymerisation catalyst, having a crystal lattice with crystal faces that are modified with respect to orientation. This modification is measurable by X-ray crystallography and/or by electron microscopy and/or by polymerisation results (determination of microstructure and/or stereoregularity of the polymer).

Preferably, modification is so t hat when an olefin polymerisation catalyst or pre-catalyst is immobilised on the surface of the support, to form a support/catalyst crystal lattice, an increased number of chiral crystal faces are formed.
This increase is measured in comparison to a corres ponding support/catalyst crystal lattice where the crystal lattice of the support has not been modified in accordance with the invention. This increase is measurable by X -ray crystallography and/or by electron microscopy and/or by electron microscopy and/or by polymerisation results (determination of microstructure and/or stereoregularity of the polymer).

The modified crystal lattice of the support thereby improves the performance of an olefin polymerisation catalyst immobilised on the support in a method for making a stereoregular polymer. The performance of the olefin polymerisation catalyst is improved because when the catalyst is immobilised on the support, a greater number of exposed active sites having the desired environment exist.

The crystal structure of the support crystal lattice is modified during growth of the lattice and a different orientation of the crystal faces is obtained as compared with the crystal lattice grown from a solution not under lattice modifying conditions. In this regard, the term "modified crystal lattice" is not intended to encompass the lattice of a crystal grown from a solution of only support where an organic agent subsequently is used to "poison" certain surfaces of the crystal. As such, the present support typically does not have an electron donor bound to any crystal face.

Until now, the orientation of crystal faces of a support crystal lattice or, more preferably, the chirality of crystal faces of a support lattice has not been controlled during lattice formation for the purpose of favouring firstly the formation of chiral or pro-chiral faces of the support crystal lattice and later the formation of topologically chiral faces of the support/catalyst lattice. This new method of control has been provided only by the present invention and is predicted to be particularly effective.

Preferably, an increased number of the crystal faces of the modified support crystal lattice are pro -chiral i.e. they provide an environment whereby exposed chiral active sites of the catalyst are formed when a catalyst is immobilised on the support. More preferably, substantially all, even more preferably all, of the crystal faces of the modified support crystal lattice provide an environment whereby chiral active sites of the catalyst are formed when a catalyst is immobilised on the support.

Preferably, an increased number of the crystal faces of the modified crystal lattice of the support are chiral or pro -chiral as compared with the unmodified crystal lattice. More preferably, substantially all, even more preferably all, of the crystal faces of the modified crystal lattice of the support are chiral or pro-chiral.

The catalyst referred to above may comprise any suitable olefin polymerisation catalyst. In this regard, Ziegler -Natta catalysts and metallocene catalysts and post -metallocene catalyst systems have been found to be particularly useful for use with the present support. These types of catalyst systems are well known to a man skilled in this art. Preferably, the catalyst is a stereospecific catalyst.

Ziegler-Natta precatalysts of particular interest are transition metal derivatives typically a halide or ester of a transition metal that may be activated with AlR₃ where R is an alkyl group. The Ziegler-Natta catalyst may be homogeneous or heterogeneous. Preferably, the activated Ziegler-Natta catalyst is TiCl₃.

In the case of a metallocene or post -metallocene catalyst, the chiral agent may be a ligand that is complexed, in the finished product, to a metallocene or post -metallocene active centre. In this embodiment, the chiral agent must have suitable properties so that it is capable of complexing with a transition metal, such as Fe, Co, Ni, Zr, or Ti, in order to create a metallocene or post-metallocene active centre. To a large extent the catalyst will be determined by the desired polyolefin. As such, in different embodiments a C₁, C₂ or Cₛ symmetric metallocene may be preferred. Generally, a Cₛ symmetric metallocene is used to produce a syndiotactic polyolefin while a C₁ or C₂ symmetric metallocene is used to produce an isotactic polyolefin.

Suitable metallocene and post -metallocene catalysts include Group VIII metal metallocene and post -metallocene catalysts, preferably Fe and Ni post-metallocenes. Zirconocene catalysts also are preferred.

Typically, the support will be inorganic. A suitable material will be determined to some extent by the olefin polymerisation catalyst system to be used. Some suitable supports for use as the present solid support will be known to a pers on skilled in the art. The support is important insofar as it must be possible to favour the formation of desirable crystal faces (exposed crystallographic planes) during precipitation of the support crystal lattice. Desirable crystal faces are as described above. In this regard, a Group IIA halide, particularly MgCl₂ as a support for Ziegler-Natta catalyst systems is preferred.

It will be appreciated that, in use, an olefin polymerisation catalyst is immobilised on the surface of the support of the present invention. As such, a second aspect according to the present invention provides a solid support as defined in the first aspect of the present invention where an olefin polymerisation catalyst or a pre-catalyst thereof is immobilised on the modified crystal lattice faces of the support. It is to be noted that in one embodiment of the present invention, the support (and specifically the chiral agent) may act as a ligand to the metal active site in the catalyst. The second aspect according to the present invention encompasses this embodiment.

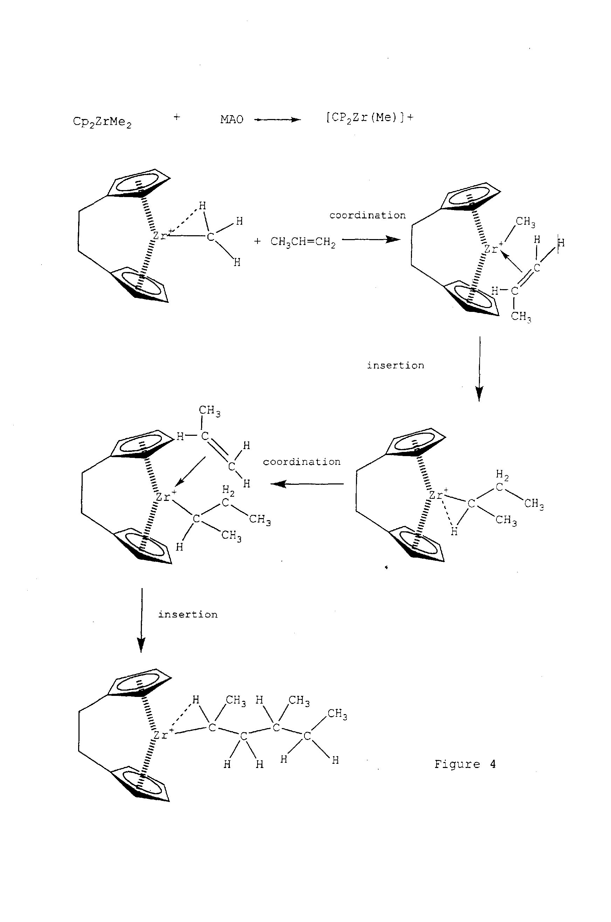

Where the catalyst system is a metallocene catalyst system the support (and specifically the chiral agent) may complex with a transition metal in order to create a metallocene active centre. As such, the chiral agent must be suitable for use in this complexing step. Originally, the term "metallocene" meant a complex with a metal sandwiched between two cyclopentadienyl (Cp) ligands. With the development of this field, this term now encompasses a wider range of organometallic structures including substituted Cp complexes, bent sandwich structure and mono Cp complexes. As for Ziegler-Natta catalyst systems, metallocene catalyst systems generally comprise a pre -catalyst and an activating agent. A widely used activa ting agent is methylaluminoxane (MAO). A mechanism for polymerisation using a metallocene catalyst system is shown in Figure 4.

As for metallocenes, where the catalyst system is a post - metallocene catalyst system, the support (and specifically the chiral agent) may complex with a transition metal in order to create a post-metallocene active centre. As such, the chiral agent must be suitable for use in this complexing step. Effectively, post-metallocenes are "Cp-free" metallocenes i.e. a complex with a metal chelated by coordinative bonds between ancillary ligands other than the usual Cp -type ligands.

Typical metallocene and post-metallocene transition metal active centres include Fe, Co, Ni, Zr and Ti.

As for Ziegler-Natta catalysts, the chiral environment of a metallocene or post-metallocene catalyst can control the stereochemical configuration of a polyolefin product. In metallocene and post-metallocene catalyst systems, the structure/geometry of the ligands can be used to control polymer architecture. In this regard, chirality is the most important element in the stereochemistry of alpha -olefin polymerisation catalyst systems. In combination with symmetry, chirality determines the nature of the crystalline alpha -olefin polymer produced (i.e. syndiotactic, isotactic, stereoblock ...).

For the catalysts based on metallocene and post -metallocene components, the chirality and symmetry of the metallocene or post-metallocene are imparted by the ancillary organic ligands.
In this regard, isotactic polypropylene is obtained using a stereorigid chiral, metallocene or post -metallocene.

Metallocenes and post-metallocenes may be heterogenized by supporting the metallocene on an inorganic or insoluble support.

Supported metallocene or post-metallocene catalysts show better long term stability and can be used to give polymers having a broad or bimodal molecular weight distribution (with improved rheological and physical properties) and higher polymer bulk density. Also, large quantities of activating agent required in homogeneous metallocene catalysis can be reduced for the heterogeneous counterpart.

A pre-catalyst eventually must be in its activated form when immobilised on the support. Activation of a pre -catalyst is achievable, for example, merely by the act of immobilising the pre-catalyst on the support or by the use of a separate activating agent.

In the second aspect of the present invention, it is preferred that an activated Ziegler-Natta, metallocene or post-metallocene catalyst or a pre-catalyst thereof is immobilised on the support.

As mentioned above, the catalyst system may be considered to comprise a pre-catalyst and an activating agent. The pre-catalyst is activated by the activating agent to form the catalyst. This will produce an activated catalyst that is immobilised on the solid support. In a preferred embodiment, a separate activating agent is not required. This is because immobilisation of the pre-catalyst on the support effectively activates the catalyst.

In the second aspect of the present invention, it is preferred that the activated catalyst has an increased number of exposed chiral active sites as compared with a corresponding catalyst that is immobilised on the crystal faces of a support where the crystal faces of the suppo rt have not been modified in accordance with the invention. More preferably, substantially all, even more preferably all, of the exposed active sites of the catalyst are chiral. Even more preferably, substantially all of the crystal faces of the support/c atalyst crystal lattice are chiral, and most preferably they are [100] faces.

In a third aspect according to the present invention, there is provided a method for making a support as defined in any aspect of the second aspect of the present invention. Th e method includes the steps of (a) forming a solid support using a chiral agent by (i) adding a chiral agent to a solution of a support; and (ii) crystallising the support from the solution to form a support crystal lattice; and (b) immobilising a catalyst or pre-catalyst thereof on the crystal faces of the support and optionally activating the pre-catalyst, to form a support as defined in any aspect of the second aspect of the present invention. The presence of the chiral agent favours the formation of crystal faces of the solid support during step (a) which faces are modified with respect to orientation.

Preferably, modification is so that when the catalyst is immobilised on the support in step (b), to form a support/catalyst crystal lattice, the modified crystal faces of the support induce formation of chiral crystal faces of the support/catalyst crystal lattice. Also preferably, modification is so that the modified crystal faces of the support induce an environment whereby exposed chiral active sites of a catalyst are formed when the catalyst is immobilised on the support in step (b).

The catalyst is an olefin polymerisation catalyst, preferably a Ziegler-Natta, metallocene or post-metallocene catalyst.

In step (b) a catalyst or pre-catalyst thereof is immobilised on the crystal surfaces of the support crystal lattice. In this regard in some cases, a precursor to the catalyst or pre-catalyst may in fact be used as a starting material. As such, the terms 'catalyst' and 'pre-catalyst' in step (b) are intended to encompass precursors thereof. In such cases, the immobilisation step will convert the precursor into the catalyst or pre-catalyst. As such, typically, no separate conversion step is needed.

Where an active catalyst is used in step (b), n o activation step is needed.

Where a pre-catalyst is used in step (b), activation of the pre-catalyst is achievable, for example, merely by the act of immobilising the catalyst on the support or by the use of a separate activating agent of the types defi ned below in relation to the fourth aspect of the present invention.

The chiral agent-induced change in surface morphology of the support crystal lattice is evidenced by more favoured crystal faces as compared with the support crystal lattice when grown i n the absence of the chiral agent. The presence of the chiral agent in the solution can thus directly modify the microscopic crystal shape of the support. Without wishing to be bound by theory it is thought that thermodynamic and kinetic factors favour the changes in surface morphology that have been observed.

The crystal faces of the support crystal lattice that are favoured in the present method need not be topologically chiral. In some cases, it is sufficient that the faces are pro -chiral i.e. they provide a chiral environment for the catalyst active sites in the support/catalyst crystal lattice when a catalyst is immobilised on the surface of the support. However, in one embodiment, preferably, the crystal faces of the support crystal lattice formed in step (a) are chiral planes.

In some cases, it is desirable to remove the chiral agent from the surface of the support after formation of the lattice. This is desirable in cases where the presence of the chiral agent could block or hinder subsequent processing steps. As such, the present method according to the third aspect of the present invention advantageously may include a step of removing the chiral agent after forming the support crystal lattice. The chiral agent may be removed by washing with a suitable organic solvent, for example toluene, or by heating and then condensing and recycling the chiral agent.

In other cases however, the chiral agent can act as a ligand for the catalyst active site. In this embodiment, it is not necessary to remove the chiral agent from the surface of the support. The chiral agent is maintained in the system so that it is able to react later with the transition metal to provide the final supported activated catalyst.

Of course, in cases where the chiral agent does not act as a ligand to the active site, the chiral agent preferably is removed and, subsequently, the catalyst or pre -catalyst thereof is added.

With regard to step (b), procedures for immobilising a catalyst or pre-catalyst thereof on the crystal f aces of the support crystal lattice will be known to a person skilled in this art.
For example, this may be achieved by addition of a transition metal chloride or by aromatisation and addition.

It has been found in the present method that the addition of chiral agents to a solution of a crystallising salt with inherent chiral elements favours the formation of crystal faces (crystallographic planes) with similar chirality. Without wishing to be bound by theory, this can be equated to a "key - lock" phenomenon i.e. the shape selectivity of a receptor for an incoming molecule.

In essence, the present method is a crystal modification method having enormous advantages when the crystal is used as a solid support for an olefin polymerisation catalyst. By growing a support crystal with preselected, favourable crystal faces, it is possible to use the support in an olefin polymerisation reaction without the addition of an electron donor to "poison" surfaces that do not provide the correct/desired environment. This greatly simplifies the polymerisation reaction and also reduces cost. Further, the avoidance of organic electron donors has environmental advantages.

Some insight into modification of crystal structure during growth of a crystal can be found from Natur e, Volume 411, 14 June 2001 "Formation of Chiral Morphologies Through Selected Binding of Amino Acids to Calcite Surface Steps".

The chiral agent has a chiral centre. Again, without wishing to be bound by theory, it is thought that binding of the chiral agent to the surface of the support crystal lattice spans the chiral centre of the chiral agent. Preferably, the chiral agent in the method according to the third aspect of the present invention is an organic chiral agent, more preferably comprising a chiral carbon atom. A chiral carbon atom usually will have four different substituents so that the carbon group cannot be superimposed to its mirror image.

In the method any chiral amino acid, such as aspartic acid, is preferred as the chiral agent.

Without wishing to be bound by theory, it is thought that the chiral agent is not introduced into the support crystal lattice. Instead, it is thought that the effects result from interactions between the support and the chiral agent at the surface of the support crystal lattice. In this regard, the effects of the chiral agent may be contrasted with the effects of impurity species where the impurity species may be incorporated into the bulk of the support crystal.

The growth of the support crystal lattice may be altered by changing the energetics at the "step edge" or across a complete crystallographic plane. As such, the chiral agent may bind to a single crystallographic plane during growth and/or to a step edge.

Prior to adding the chiral agent the concentrati on of the support solution preferably is in the range 1 to 10 mole/L.

The chiral agent preferably should be added to the support solution at a temperature in the range of from 25°C to 100°C. The optimum temperature will depend upon the desired final concentration of the chiral agent in the solution. A higher temperature will allow the addition of more chiral agent to the solution.

The optimum concentration for a particular chiral agent in the support solution may be determined by experiment, startin g first at low concentrations and continuing at higher concentrations until the solution is saturated.

All other growing conditions for the support crystal lattice may be taken to be standard and well known to a person skilled in this art.

Taking an MgCl₂ support and a Ziegler-Natta catalyst system as an example, in the method according to the third aspect of the present invention, a chiral agent is added during crystallisation of the MgCl₂ support. This will eliminate or reduce the possibility of the formation of [110] faces that are believed to be responsible for the formation of atactic sites in the final catalyst. Lowering the probability of creating such planes eliminates or largely reduces the need for the addition of internal donors and leads to t he formation of highly stereospecific sites due to the formation of perfect [100] crystallographic planes.

For single site catalysts, the present method can be used for the direct preparation of a chiral support.

In a fourth aspect according to the pres ent invention, there is provided a method for producing a polyolefin, which method comprises polymerising an olefin monomer in the presence of a support having an olefin polymerisation catalyst immobilised on the crystal faces thereof as defined in the fir st aspect of the present invention. In the method, the olefin polymerisation catalyst will be immobilised on the solid support to form a support/catalyst crystal lattice as defined above. The system may comprise further catalysts, if necessary.

The catalyst system of the present invention may comprise a pre - catalyst and one or more activating agents capable of activating the pre-catalyst. Typically, the activating agent comprises an aluminium- or boron- containing activating agent.

Suitable aluminium-containing activating agents comprise an alumoxane, an alkyl aluminium compound and/or a Lewis acid.
Alumoxane activating agents are suitable for metallocene or post-metallocene catalysts. The alumoxanes that can be used in the present invention are well known and preferably comprise oligomeric linear and/or cyclic alkyl alumoxanes represented by the formula (A): 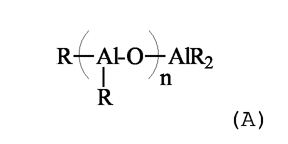 for oligomeric linear alumoxanes; and formula (B) 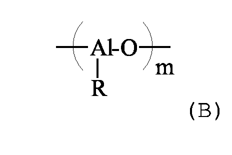 for oligomeric cyclic alumoxanes,
wherein n is 1-40, preferably 10-20; m is 3-40, preferably 3-20; and R is a C₁-C₈ alkyl group, preferably methyl. Generally, in the preparation of alumoxanes from, for example, aluminium trimethyl and water, a mixture of linear and cyclic compounds is obtained.

Other preferred activating agents inc lude hydroxy isobutylaluminium and metal aluminoxinates. These are particularly preferred for metallocenes as described in Main Group Chemistry, 1999, Vol. 3, pg 53-57; Polyhedron 18 (1999), 2211-2218; and Organometallics 2001, 20, 460-467.

In the embodiment where the catalyst is TiCl₃, it is preferred that TEAL (triethyl aluminium) also is present with the catalyst. For a metallocene precatalyst, it is preferred that the activating agent comprises MAO (methyl alumoxane), boron, and either hydroxyisobutyl aluminium or a metal aluminoxinate. For a post-metallocene catalyst, it is preferred that the activating agent comprises MAO and boron.

Suitable boron-containing activating agents may comprise a triphenylcarbenium boronate, such as tetrakis-pentafluorophenylborato-triphenylcarbenium as described in EP-A-0427696: 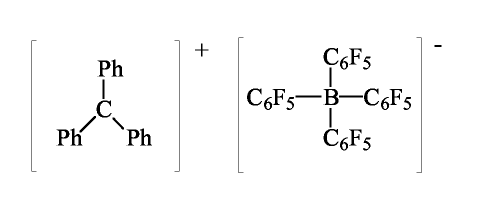 or those of the general formula below, as described in EP-A-0277004 (page 6, line 30 to page 7, line 7):

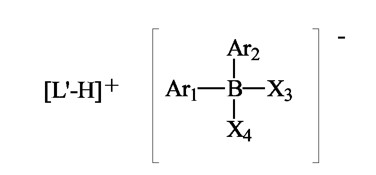

The amount of alumoxane usefully employed in the preparation of the solid support catalyst can vary over a wide range. Generally the aluminium to transition metal mole ratio is in the range between 1:1 and 100:1, preferably in the range 5:1 and 80:1 and more preferably in the range 5:1 and 50:1.

Preferred or suitable polymerisation conditions will be dependent on the catalyst, the polyolefin product and the polymerisation technique.

The method preferably is for preparing a stereoregular polypropylene, more preferably an isotactic, syndiotactic or stereoblock polypropylene or polyethylene.

In the method according to the fourth aspect of the present invention, preferably, the olefin monomer is propylene or ethylene.

The conditions under which polymerisation is carried out are not especially limited.

Typically, the polymerising step is carried out as a solution, gas, or slurry polymerisation process. Further, the polymerising step conveniently may be carried out in a loop reactor.

In a fifth aspect of the present invention, there is provided a polyolefin obtainable by or obtained by the method according to the fourth aspect of the present invention.

The use of the solid support as defined in relation to the first aspect of the present invention for the purpose of supporting an olefin polymerisation catalyst in the preparation of a polyolefin also is provided. Preferably, the use is for the preparation of a stereoregular polypropylene, more preferably an isotactic, syndiotactic, or stereoblock polypropylene or polyethylene.

Further, the use of a chiral agent as defined above in rel ation to the third aspect of the present invention for the purpose of controlling the orientation of the crystal faces of the crystal lattice of a solid support for an olefin polymerisation catalyst also is provided.

The present invention now will be described in more detail with reference to the attached Figures in which:
Figure 1 shows a proposed mechanism for polymerisation using a Ziegler-Natta catalyst;
Figure 2 shows crystal faces of titanium tetrachloride supported on magnesium dichloride;
Figure 3 shows the symmetry of MgCl₂ - supported titanium tetrachloride;
Figure 4 shows a mechanism for polymerisation using a metallocene catalyst;

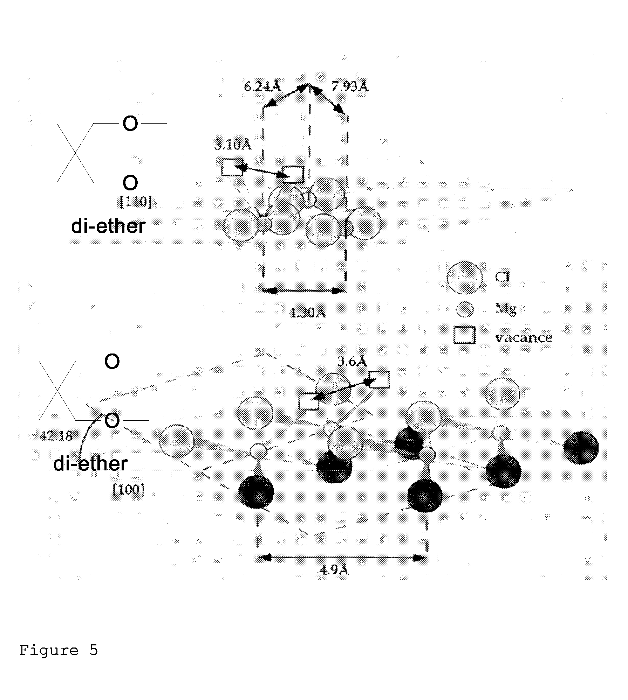

Figure 5 shows the difference in geometry between a [110] plane and a [100] plane in an MgCl₂ crystal lattice. A difference in distance between vacant sites leads to a difference in coordination number of the Mg. This, in turn, causes a difference in electrophilic character.

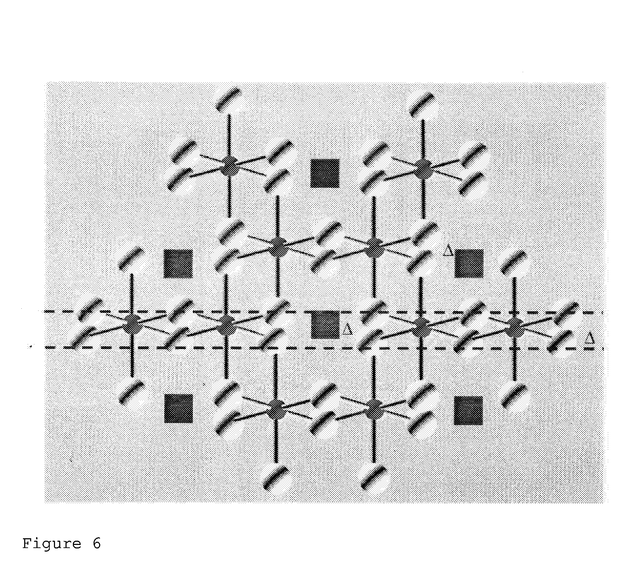

Figure 6 represents the crystal lattice of α-TiCl₃.

## Claims

1. A solid support having a crystal lattice with crystal faces that are modified with respect to orientation **characterised in that** an olefin polymerisation catalyst or a pre -catalyst thereof is immobilised on the modified crystal faces.

2. A support according to claim 1, wherein the support crystal lattice has an increased number of chiral or pro -chiral crystal faces.

3. A support according to claim 2, wherein substantially all of the crystal faces of the crystal lattice are chiral or p rochiral.

4. A support according to any one of the preceding claims, wherein the support is inorganic.

5. A support according to any one of the preceding claims, wherein the catalyst has an increased number of chiral exposed active sites.

6. A support according to claim 5, wherein substantially all of the exposed active sites of the catalyst are chiral.

7. A support according to any one of the preceding claims, wherein the catalyst is a Ziegler-Natta catalyst.

8. A support according to any one of claims 1 to 6, wherein the catalyst is a metallocene or post -metallocene catalyst.

9. A support according to claim 7 or claim 8, wherein the catalyst is a stereospecific catalyst.

10. A support according to any one of claims 7 to 9, wherein the support crystal lattice acts as a ligand to the active sites of the catalyst.

11. A method for making a support as defined in any one of the preceding claims, including the steps of:
(a) forming a solid support using a chiral agent by:
(i) adding a chiral agent to a solution of a support; and
(ii) cyrstallising the support from the solution to form a support crystal lattice,
whereby the presence of the chiral agent favours the formation of crystal faces of the support crystal lattice in step (a), which faces are modified with respect to orientation and;
(b) immobilising a catalyst or pre-catalyst thereof on the modified crystal faces, and optionally activating the pre - catalyst, to form a support as defined in any one of the preceding claims,
**characterised in that** the catalyst is an olefin polymerisation catalyst.

12. A method according to claim 11, wherein step (a) includes a step of removing the chiral agent after forming the support crystal lattice.

13. A method according to claim 12, wherein the chiral agent is an organic chiral agent.

14. A method according to claim 13, wherein the organic chiral agent is an amino acid.

15. A method according to any one of claims 11 to 14, wherein the chiral agent is added in step (a) until the solution is saturated.

16. A method according to any one of claims 11 to 15, wherein the chiral agent is added at a temperature in the range of from 25 to 100°C.

17. A method according to any one of claims 11 to 16, wherein the chiral agent is added to a solution containing 1 to 10 mole/L of a support.

18. A method for producing a polyolefin, which method comprises polymerising an olefin monomer in the presence of a support as defined in any one of claims 1 to 10.

19. A method according to claim 18, wherein the olefin monomer is propylene or ethylene.

20. A polyolefin obtainable by a method as defined in claim 18 or claim 19.

21. Use of a solid support having a crystal lattice with crystal faces that are modified with respect to orientation for the purpose of supporting an olefin polymerisation catalyst in an olefin polymerisation reaction.

22. Use according to claim 21, wherein the polyolefin is polypropylene or polyethylene.

23. Use of a chiral agent as defined in any one of claims 11 to 14, for the purpose of controlling the orient ation of the crystal faces of the crystal lattice of a solid support for an olefin polymerisation catalyst.
